# EUROPÄISCHE PATENTSCHRIFT

(11) **EP 3 376 900 B1**
(45) Veröffentlichungstag und Bekanntmachung des Hinweises auf die Patenterteilung: **05.01.2022**
(21) Anmeldenummer: 16797753.7
(22) Anmeldetag: 03.11.2016
(51) Int. Cl.: A47B 96/20, B32B 17/00, E04F 15/00, E04B 2/72, E04C 2/00, H02G 3/38, H05K 3/00

(54) **BELAGSELEMENT**
COVERING ELEMENT
ÉLÉMENT DE REVÊTEMENT

(30) Priorität: 17.11.2015 DE 202015007865 U; 20.11.2015 DE 202015007999 U; 10.06.2016 DE 102016007084
(43) Veröffentlichungstag der Anmeldung: 26.09.2018
(73) Patentinhaber: Parador GmbH, 48653 Coesfeld (DE)
(72) Erfinder: WOLF, Matthias, 48653 Coesfeld-Lette (DE); DAMIECKI, David, 48653 Coesfeld (DE); PETERSEN, Frank, 48653 Coesfeld (DE)
(74) Vertreter: Von Rohr Patentanwälte Partnerschaft mbB
(86) Internationale Anmeldenummer: PCT/EP2016/025136
(87) Internationale Veröffentlichungsnummer: WO 2017/084761

(56) Entgegenhaltungen:
- WO-A1-2016/080346
- DE-A1- 10 239 579
- DE-U1-202014 003 058

## Beschreibung

Die Erfindung betrifft ein Belagselement für einen Boden, Wand- oder Deckenbelag oder zur Verwendung als Möbelbauteil, insbesondere einen Plattenkörper oder eine Folie, mit einer Trägerschicht und mit wenigstens einer Funktionsschicht.

Im Sinne einer fortschreitenden Technisierung und Automatisierung, insbesondere im Bereich der Gebäudetechnik, werden Boden-, Wand- oder Deckenbeläge, aber auch Möbelstücke, zum Teil mit einer erweiterten Funktionalität ausgestattet. Von rein passiven Bauteilen unterscheiden sich solche aktiven Einrichtungselemente durch oftmals integrierte funktionale Komponenten. Hierzu zählen beispielsweise Sensoren zur Erfassung von Umgebungsgrößen, wie der Temperatur, der Luftfeuchtigkeit oder dem Geräuschniveau. Ferner können Aktoren vorgesehen sein, die etwa einer Signalisierung in optischer oder akustischer Form dienen oder als mechanische Aktoren ausgebildet sind. Die Energieversorgung und die Ansteuerung solcher aktiven Komponenten geschieht in der Regel über elektronische Schaltungen und Leiterbahnen. Durch die Integration derartiger aktiver Komponenten in Bauteile, wie Belagselemente oder Möbelbauteile, ergeben sich vielfältige Möglichkeiten, eine erweiterte Funktionalität in unauffälliger Weise in eine bestehende Einrichtung zu integrieren und beispielsweise Wohn- oder Arbeitsbereiche mit einer gewünschten Funktionalität auszurüsten, ohne dass funktionale Elemente bei Nicht-Benutzung sichtbar sind.

Zur Bereitstellung einer solchen integrierten Funktionalität können Belagselemente mit einer Funktionsschicht ausgestattet sein, die ihrerseits eine gedruckte Schaltung aufweist. Ein entsprechendes Belagselement in Form eines Plattengrundkörpers mit einer elektrisch leitfähigen Schicht ist beispielsweise aus der WO 2013/013693 A1 bekannt. Dadurch ist es möglich, elektronische Komponenten in einer äußerst raumsparenden Weise bereitzustellen, insbesondere in Bezug auf die Dicke der Strukturen. Dennoch ist es häufig so, dass Strukturen der gedruckten Schaltung einer solchen Funktionsschicht auch trotz der Anordnung von darüber liegenden Schichten im Schichtenverbund des Belagselements an der Oberfläche des fertigen Produktes als störende Reliefkontur wahrnehmbar sind. Dies gilt umso mehr im Falle von Komponenten, die aufgrund ihres Funktionsprinzips nah zur Oberfläche eines Belagselements angeordnet werden müssen. Hierzu zählen beispielsweise Helligkeitssensoren oder Anzeigeelemente sowie die entsprechenden Leiterbahnen zur Kontaktierung. Ein weiteres gattungsgemäßes Belagselement is bspw. aus der DE 20 2014 003058 U1 bekannt.

Vor diesem Hintergrund ist Aufgabe der vorliegenden Erfindung, diesbezüglich Abhilfe zu schaffen und ein Belagselement bereitzustellen, bei dem die vorgenannte Problematik von störenden Konturen an der Oberfläche im Zusammenhang mit der Bereitstellung einer erweiterten Funktionalität nicht auftritt.

Die vorgenannte Aufgabe wird erfindungsgemäß gelöst durch ein Belagselement mit den Merkmalen des Anspruchs 1. Vorteilhafte Weiterbildungen sind Gegenstand der Unteransprüche.

Eine Negativmaskenschicht zum Ausgleich von überstehenden Konturen der Funktionsschicht dient insbesondere dazu, die Zwischenräume zwischen den überstehenden Konturen, die beispielsweise von einer gedruckten Schaltung gebildet werden, auszufüllen. Anders ausgedrückt weist die Negativmaskenschicht eine oder mehrere entsprechende Aussparungen zur Aufnahme von überstehenden Konturen der Funktionsschicht auf. Dabei kann zwischen den überstehenden Konturen der Funktionsschicht und dem Material der Negativmaskenschicht ein unmittelbarer Kontakt bestehen. Alternativ können die Aussparungen der Negativmaskenschicht auch derart großzügig bemessen sein, dass die überstehenden Konturen mit einem gewissen Spiel darin Platz finden.

Letztlich ist es bei der Erfindung so, dass die Negativmaskenschicht durch den Ausgleich des Oberflächenreliefs, das sich im Bereich der Funktionsschicht durch die gedruckte Schaltung und andere Komponenten ergibt, bewirkt, dass nach außen hin eine glatte Oberfläche entsteht, das heißt, dass keine störenden Konturen von außen optisch oder haptisch wahrnehmbar sind, die aufgrund von überstehenden Konturen der Funktionsschicht gebildet werden.

Hierzu ist es bevorzugt so, dass die der Funktionsschicht abgewandte Seite der Negativmaskenschicht zumindest im wesentlichen über ihre gesamte Fläche eben ist, und zwar sowohl im auf die Funktionsschicht aufgebrachten Zustand als auch im nicht aufgebrachten Zustand, falls die Negativmaskenschicht als separate Schicht, beispielsweise als Folie, bereitgestellt und anschließend dem Schichtenverbund des Belagselements hinzugefügt wird. Durch den Ausgleich der durch die überstehenden Konturen der Funktionsschicht hervorgerufenen Höhenunterschiede mittels der Negativmaskenschicht wird eine ebene Grundlage geschaffen, um weitere Schichten des Schichtenverbunds eines erfindungsgemäßen Belagselements ebenfalls eben auf der Negativmaskenschicht anzuordnen, so dass letztlich alle Schichten von ihren Basisoberflächen her parallel zueinander verlaufen.

Es versteht sich, dass die Negativmaskenschicht erfindungsgemäß nicht nur einem Ausgleich von nach oben überstehenden Konturen der Funktionsschicht dienen kann, so dass eine fühlbar glatte Oberfläche an der Außenseite des Belagselements entsteht. Gleichsam ist es bei einer Funktionsschicht, die unterhalb der Trägerschicht eines Belagselements angeordnet ist und nach unten überstehende Konturen aufweist, möglich, eine Negativmaskenschicht derart anzuordnen, dass eine nach außen hin glatte Oberfläche an der Unterseite des Belagselements erreicht wird. Hierdurch wird eine ebene Auflage des Belagselements auf einem Untergrund, beispielsweise auf einem Boden, an einer Wand oder an einer Decke, erreicht. Hierdurch wird zum einen eine hohe Lagestabilität des Belagselements in seiner Position erreicht. Ein Wackeln des Belagselements aufgrund einer nur punktuellen Auflage auf dem Untergrund wird also vermieden. Zum anderen erfährt die Funktionsschicht bzw. ihre überstehenden Strukturen in Form einer gedruckten Schaltung und andere funktionaler Komponenten eine hohe mechanische Belastung, wenn ein Belagselement, beispielsweise als Teil eines Bodenbelags, lediglich bereichsweise oder punktuell auf den unebenen Strukturen aufliegt, die durch die überstehenden Konturen der Funktionsschicht an der Unterseite des Belagselements gebildet werden. Die Negativmaskenschicht dient also zusätzlich auch einem Schutz der Funktionsschicht bzw. ihrer Strukturen. Letzteres gilt sowohl bei einer Anordnung der Funktionsschicht unterhalb der Trägerschicht als auch oberhalb von dieser.

Um eine ebene Oberfläche an der Außenseite des Belagselement zu erhalten, ist es grundsätzlich möglich, die Höhenunterschiede, die sich aufgrund der überstehenden Konturen der Funktionsschicht auch durch mehrere anliegende Schichten abzeichnen, an einer nahezu beliebigen Position im Schichtenverbund des Belagselements mittels einer Negativmaskenschicht auszugleichen. Bevorzugt ist die Negativmaskenschicht jedoch unmittelbar oberhalb und/oder unterhalb der Funktionsschicht angeordnet. Somit lassen sich die Zwischenräume zwischen den überstehenden Konturen der Funktionsschicht unmittelbar und auf exakte Weise ausfüllen, so dass eine besonders ebene Oberfläche erreicht werden kann. Zudem ist es vorteilhaft für die weiteren Schichten des Schichtenverbunds und im Fall einer Dekorschicht in der Regel auch notwendig, dass die Schichten als ebene Schichten ausgebildet sind bzw. aufgetragen werden können, das heißt, dass keine hervorstehenden Strukturen und insbesondere keine scharfen Kanten von der Schicht überdeckt bzw. umlaufen werden müssen. Bei einer Dekorschicht ergeben sich hierdurch andernfalls Störungen bzw. Sprünge im Dekorbild, die von außen durch eine transparente Deckschicht wahrnehmbar sein können, selbst wenn diese durch eine vorzugsweise ebenfalls transparente Negativmaskenschicht oberhalb der Dekorschicht an ihrer Oberfläche eben ist.

Von besonderem Vorteil ist es, wenn durch die Negativmaskenschicht eine ebene Oberfläche zur Anordnung weiterer Schichten großflächig oder bevorzugt vollflächig gewährleistet wird. Hierzu erstreckt sich die Negativmaskenschicht lateral, d. h. in der Ebene bzw. auf die Fläche bezogen, vorzugsweise zumindest im wesentlichen über das gesamte Belagselement. Es wird dadurch insbesondere vermieden, dass an einem Rand der Negativmaskenschicht eine neue Kontur entsteht, die sich durch weitere Schichten fortsetzt und gegebenenfalls an der Oberfläche des Belagselements fühl- und/oder sichtbar ist. Die Negativmaskenschicht kann also auch in Bereichen vorgesehen sein, in denen keine Funktionsschicht bzw. keine funktionalen Elemente der Funktionsschicht mit überstehenden Konturen vorgesehen sind. In diesem Fall werden also von der Negativmaskenschicht durch Aufnahme der überstehenden Konturen der Funktionsschicht in entsprechende Aussparungen nicht nur die Zwischenräume zwischen den überstehenden Konturen der Funktionsschicht aufgefüllt, sondern auch funktionsschichtfreie Bereiche oder solche Bereiche der Funktionsschicht, in denen großflächig keine funktionalen Elemente, also insbesondere eine gedruckte Schaltung, vorgesehen sind.

Die Negativmaskenschicht wird erfindungsgemäß durch einen Teil der Trägerschicht gebildet

ln diesem Fall ist es so, dass die Trägerschicht auf ihrer der Funktionsschicht zugewandten Seite, vorzugsweise im an die Funktionsschicht angrenzenden Bereich, Aussparungen zur Aufnahme von überstehenden Konturen der Funktionsschicht aufweist. Die Aussparungen sind hierbei erfindungsgemäß durch Einprägen oder Einfräsen in die Trägerschicht eingebracht.

Auch hierbei ist es möglich, auf die Daten zur Erzeugung der Strukturen der Funktionsschicht, also insbesondere der gedruckten Schaltung, zurückzugreifen.

Anstelle einer zusätzlichen bzw. separaten Dekorschicht kann auch die Negativmaskenschicht als Dekorschicht ausgebildet sein. Hierzu kann sie durch ihre Beschaffenheit als solche einen bestimmten optischen Eindruck hervorrufen, der gestalterisch genutzt wird. Alternativ eignet sich die Negativmaskenschicht insbesondere auf ihrer ebenen Seite gegebenenfalls auch als Träger für ein vorzugsweise aufgedrucktes Dekor. Hierdurch lässt sich eine besonders geringe Gesamtdicke des Schichtenverbunds erzielen. Es versteht sich, dass auch im Fall eines Dekors auf der Negativmaskenschicht oder deren allgemein gestalterischer Nutzung eine zusätzliche Dekorschicht zumindest bereichsweise bei dem erfindungsgemäßen Belagselement vorgesehen sein kann.

Je nach Materialbeschaffenheit der Negativmaskenschicht, insbesondere in Bezug auf die mechanische Stabilität bzw. Robustheit und die Widerstandsfähigkeit gegen Umwelteinflüsse, beispielsweise gegen Temperaturveränderungen, Feuchtigkeit und UV- oder Wärmestrahlung, eignet sich die Negativmaskenschicht bei einer weiteren bevorzugten Ausführungsform des erfindungsgemäßen Belagselements auch dazu, als oberseitige Deckschicht zu fungieren. Die Negativmaskenschicht erfüllt damit zur Unterseite hin die Aufgabe des Ausgleichs der Höhenunterschiede durch die überstehenden Strukturen der Funktionsschicht und zur Oberseite hin eine Funktion als Schutzschicht für das Belagselement bzw. für die tieferliegenden Schichten des Belagselements. Von der Herstellung her ist es dabei insbesondere möglich, in ein übliches Material für eine Deckschicht, beispielsweise ein Melaminharz, entsprechende Aussparungen von der Unterseite her einzubringen, wodurch der Deckschicht die Funktionalität als Negativmaskenschicht verliehen wird. Die

Einbringung der Aussparungen in eine solche Deckschicht geschieht erfindungsgemäß durch Schneiden oder Fräsen.

Damit das Dekor der Dekorschicht von außen her erkennbar ist, sind die Schichten oberhalb der Dekorschicht vorzugsweise transparent ausgebildet. Dies gilt insbesondere für die Deckschicht, auch dann, wenn diese zusätzlich die Funktion einer Negativmaskenschicht übernimmt. Im Falle einer Funktionsschicht, die funktionale Elemente enthält, die von außen wahrnehmbar sein sollen, beispielsweise eine Leuchtschicht oder eine Anzeigeeinrichtung, sind in entsprechender Weise die über der Funktionsschicht angeordneten Schichten vorzugsweise transparent oder zumindest transluzent, d. h. durchscheinend, ausgebildet.

Insbesondere sollte eine oberhalb der Funktionsschicht angeordnete Negativmaskenschicht in einem solchen Fall durchsichtig oder zumindest lichtdurchlässig sein.

Durch eine Kombination verschieden stark lichtdurchlässiger Materialien bzw. deren laterale bzw. flächige Anordnung in der Negativmaskenschicht lassen sich zudem bewusst bestimmte Bereiche einer darunterliegenden Schicht, also beispielsweise einer eine großflächige Leuchtschicht aufweisenden Funktionsschicht, maskieren. Somit kann gestalterisch auf das Aussehen des Belagselements Einfluss genommen werden.

Das erfindungsgemäße Belagselement ist selbstverständlich nicht auf eine einzelne Funktionsschicht beschränkt. Erfindungsgemäß ist es durchaus möglich, dass eine Mehrzahl von Funktionsschichten vorgesehen ist. In diesem Fall ist bevorzugt jeder Funktionsschicht wenigstens eine eigene Negativmaskenschicht zugeordnet. Dadurch wird sichergestellt, dass überstehende Konturen einer jeden Funktionsschicht korrekt ausgeglichen werden, so dass sich für nachfolgende Schichten, insbesondere weitere Funktionsschichten eine ebene Auflagefläche ergibt.

Die gedruckte Schaltung einer Funktionsschicht der in Rede stehenden Art lässt sich besonders leicht durch die Verwendung eines leitfähigen Materials in Verbindung mit einer Standarddrucktechnik erzeugen. Hierbei bietet sich insbesondere der Digitaldruck an. Die gedruckte Schaltung wird hierbei unter Verwendung einer leitfähige Elemente, beispielsweise Silberpigmente, aufweisenden Tinte auf eine Oberfläche aufgedruckt. Im Fall einer anderen Drucktechnik, wie beispielsweise dem Siebdruck und/oder dem Rollenoffsetdruck wird üblicherweise eine entsprechende, ebenfalls leitfähige Elemente aufweisende Druckfarbe eingesetzt.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst. Dabei bilden alle beschriebenen und/oder bildlich dargestellten Merkmale für sich oder in beliebiger Kombination den Gegenstand der vorliegenden Erfindung, unabhängig von ihrer Zusammenfassung in den Ansprüchen oder deren Rückbeziehung.

Es zeigt
- Fig. 1: eine schematische Querschnittsansicht eines nicht erfindungsgemäßen Belagselements ohne Negativmaskenschicht,
- Fig. 2: eine schematische Querschnittsansicht eines nicht erfindungsgemäßen Belagselements,
- Fig. 3: eine schematische Querschnittsansicht des nicht erfindungsgemäßen Belagselements,
- Fig. 4: eine schematische Querschnittsansicht einer ersten Ausführungsform des erfindungsgemäßen Belagselements,
- Fig. 5: eine schematische Querschnittsansicht einer weiteren alternativen Ausführungsform des erfindungsgemäßen Belagselements, und
- Fig. 6: eine schematische Querschnittsansicht einer weiteren bevorzugten Ausführungsform des erfindungsgemäßen Belagselements.

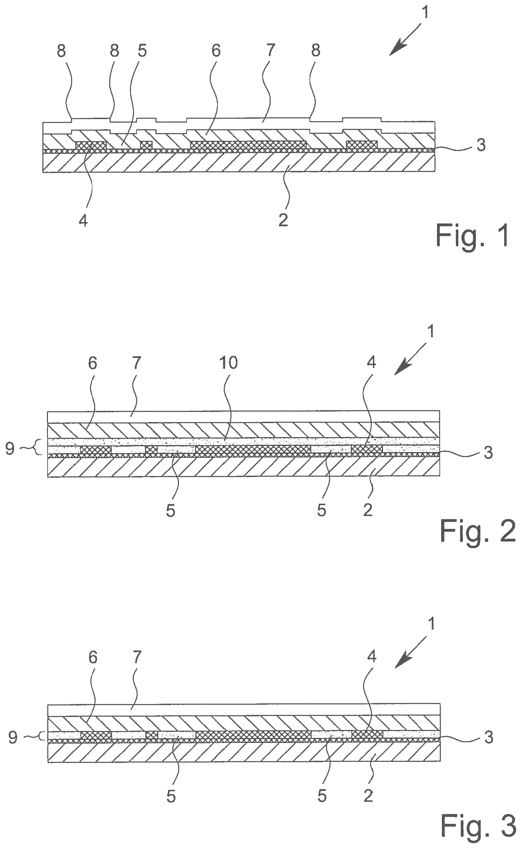

Die Darstellung gemäß Fig. 1 verdeutlicht das Problem, welches der Erfindung zugrunde liegt. Dort ist ein Belagselement 1 gezeigt, das eine Trägerschicht 2 aufweist. Die Trägerschicht 2 kann je nach Einsatzbereich des Belagselements 1 beispielsweise als reißfeste Papierschicht für eine Folie ausgebildet sein oder aber als Trägerplatte, insbesondere aus einem Holzwerkstoff, für einen starren Plattenkörper.

Angrenzend an die Trägerschicht 2 ist oberhalb von dieser eine Funktionsschicht 3 vorgesehen, die dem Belagselement 1 eine erweiterte Funktionalität verleiht. Hierzu weist die Funktionsschicht 3 funktionale Elemente in Form einer gedruckten Schaltung auf. Die Strukturen der gedruckten Schaltung ragen als überstehende Konturen 4 von der Funktionsschicht 3 zur der Trägerschicht 2 abgewandten Seite ab. Aus den überstehenden Konturen 4 und Zwischenräumen 5 zwischen diesen ergibt sich ein sich lateral über das Belagselement 1 erstreckendes Höhenprofil.

Oberhalb der Funktionsschicht 3 sind bei dem hier gezeigten Belagselement 1 weitere Schichten vorgesehen. Zum einen weist das Belagselement 1 eine Dekorschicht 6 auf, die dem Belagselement 1 ein bestimmtes optisches Erscheinungsbild verleiht. Zum anderen ist als oberste Schicht eine Deckschicht 7 vorgesehen. Die Deckschicht 7 dient bei Belagselementen 1 der gezeigten Art dazu, den Schichtaufbau des Belagselements 1 vor Feuchtigkeit, Abnutzung und/oder mechanischer Beschädigung zu schützen.

Selbst bei einem nur minimalen Höhenaufbau durch den Druck einer elektronischen Schaltung setzt sich die Form der überstehenden Konturen 4 der Funktionsschicht 3 durch die darüberliegenden Schichten fort, da die oberen Schichten aufgrund ihrer vergleichsweise geringen Schichtdicke und der Flexibilität ihres Materials beim Herstellungsvorgang des Belagselements 1, beispielsweise beim Verpressen, der Form der darunterliegenden Strukturen zumindest im wesentlichen folgen. Infolgedessen kommt es an der Oberseite des Belagselements 1 zur Ausbildung eines Reliefs, das die Strukturen der Funktionsschicht 3 widerspiegelt. Insbesondere treten fühlbare und sichtbare Kanten 8 an der Oberfläche auf, die durch einen abrupten Höhenunterscheid gekennzeichnet sind, wenngleich die Kanten 8 tatsächlich etwas weniger scharf als dargestellt ausgebildet sind.

Bei dem in Fig. 2 gezeigten, nicht erfindungsgemäßen Belagselement 1 ist zum Ausgleich der Höhenunterschiede, die sich aus den überstehenden Konturen 4 der Funktionsschicht 3 im Schichtaufbau des Belagselements 1 ergeben, eine Negativmaskenschicht 9 vorgesehen. Bei dem hier dargestellten Beispiel eines Belagselements 1 ist die Negativmaskenschicht 9 unmittelbar oberhalb der Funktionsschicht 3 angeordnet.

Vorliegend wird die Negativmaskenschicht 9 durch einen vorzugsweise UVaushärtenden oder oxidativ aushärtenden Schutzlack gebildet. Der Schutzlack weist vor dem Aushärten eine zur Verarbeitung ausreichend niedrige Viskosität auf, so dass die Negativmaskenschicht 9 ohne weiteres in die Zwischenräume 5 zwischen den überstehenden Konturen 4 der Funktionsschicht 3 eindringen und diese ausfüllen kann. Somit bewirkt die Negativmaskenschicht 9 einen Niveauausgleich zwischen den überstehenden Konturen 4 der Funktionsschicht 3.

Ein Auffüllen der Zwischenräume 5 würde grundsätzlich ausreichen, um zusammen mit den überstehenden Konturen 4 eine weitgehend ebene Fläche als Basis für die darauffolgenden Schichten zu bilden. Die Bereitstellung einer absolut ebenen Fläche erfolgt im vorliegenden Ausführungsbeispiel insbesondere durch eine zusätzliche, durchgehende Lackschicht 10 oberhalb der überstehenden Konturen 4. Die weiteren, das heißt oberhalb folgenden, Schichten lassen sich dadurch in guter Näherung absolut plan auf die ununterbrochene Lackschicht 10 der Negativmaskenschicht 9 aufbringen. Wird auf eine ununterbrochene Lackschicht 10 verzichtet, wie es bei der in Fig. 3 dargestellten Ausführungsform der Fall ist, so ist die Oberseite der Negativmaskenschicht 9 insbesondere mit den überstehenden Konturen 4 bzw. mit der höchsten überstehenden Kontur 4 ausgefluchtet.

Bei der in Fig. 2 und 3 gezeigten Ausführungsform des nicht erfindungsgemäßen Belagselements 1 folgen auf die Negativmaskenschicht 9 eine Dekorschicht 6 zur Gestaltung des Erscheinungsbilds des Belagselements 1 und eine dem Schutz der darunter liegenden Schichten dienende Deckschicht 7. Im Ergebnis verlaufen die Dekorschicht 6 und die Deckschicht 7 insbesondere an ihrer Oberfläche jeweils plan und parallel zur Ebene der der Funktionsschicht 3 abgewandten Seite der Negativmaskenschicht 9, das heißt im vorliegenden Fall zur ununterbrochenen Lackschicht 10.

Die Oberseite der Lackschicht 10 und damit der Negativmaskenschicht 9 als solcher verläuft insbesondere parallel zur Oberseite der Funktionsschicht 3, das heißt in der Regel zu der Oberfläche, von der die überstehenden Konturen 4 der Funktionsschicht 3 abragen. Bei einem direkten Druck der funktionalen Elemente der Funktionsschicht 3 auf eine weitere Schicht des Schichtaufbaus des Belagselements 1, beispielsweise auf die Trägerschicht 2, bildet die Oberfläche, auf weiche die Schaltung bzw. die funktionalen Elemente aufgedruckt sind, im Sinne einer Basisfläche die Oberfläche der Funktionsschicht 3.

Im einzelnen nicht bildlich dargestellt ist ein Beispiel eines Belagselements 1, bei dem eine Mehrzahl von Funktionsschichten 3 mit jeweils überstehenden Konturen 4 vorgesehen ist. In diesem Fall ist es vorzugsweise so, dass jeder der Funktionsschichten 3 jeweils wenigstens eine Negativmaskenschicht 9 zugeordnet ist. Der in Fig. 2 oder 3 gezeigte Schichtaufbau mit aufeinanderfolgender Funktionsschicht 3 und Negativmaskenschicht 9, gegebenenfalls einschließlich einer ununterbrochenen Lackschicht 10, wiederholt sich in diesem Fall bevorzugt in entsprechender Weise. Dabei versteht es sich, dass die laterale Anordnung der überstehenden Konturen 4 infolge einer unterschiedlichen Ausbildung der Funktionsschichten 3 unterschiedlich sein kann.

Anstelle eines Schutzlacks kommt für die Negativmaskenschicht 9 bei dem in Fig. 2 gezeigten Beispiel des Belagselements 1 auch eine entsprechend ausgestaltete Folie in Frage, die dem Schichtaufbau des Belagselements 1 vor seiner Fertigstellung hinzugefügt wird und Aussparungen aufweist, die den überstehenden Konturen 4 der Funktionsschicht 3 von ihrer Form und Anordnung im wesentlichen entsprechen und zu deren Aufnahme dienen.

Über das Material der Negativmaskenschicht 9 in den Zwischenräumen 5 zwischen den überstehenden Konturen 4, das heißt letztlich zwischen den Aussparungen der Negativmaskenschicht 9, wird ein von der Oberseite her auf das Belagselement 1 wirkender Druck auf die Trägerschicht 2 übertragen. Es wird dementsprechend eine ausschließliche Einwirkung des Drucks auf die überstehenden Konturen 4 der Funktionsschicht 3 vermieden, wie sie im Fall des in Fig. 1 gezeigten Belagselements 1 ohne Negativmaskenschicht 9 auftritt. Die Strukturen der Funktionsschicht 3 werden somit vor einer mechanischen Beschädigung weitgehend geschützt, was zu einer erhöhten Langlebigkeit des Belagselements 1 bzw. dessen integrierter Funktionalität beiträgt.

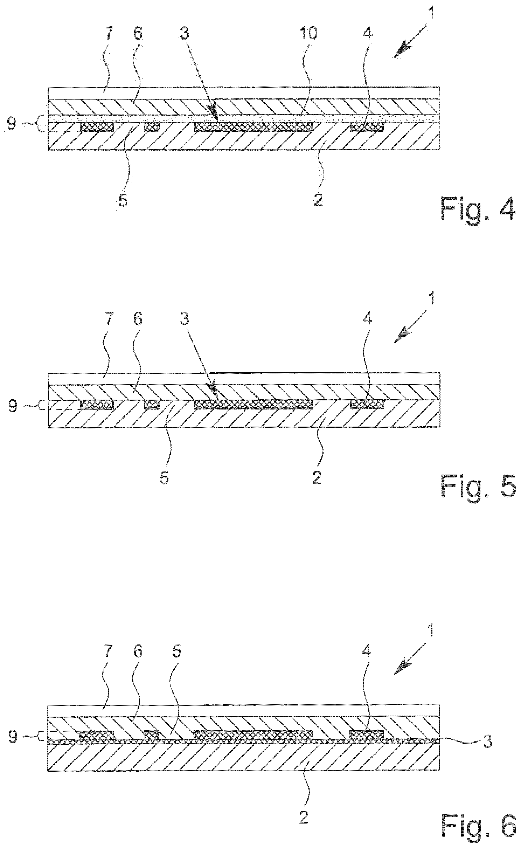

Eine Ausführungsform des erfindungsgemäßen Belagselements 1 ist in Fig. 4 dargestellt. Bei dieser ist die Trägerschicht 2 derart ausgestaltet, dass in ihrem oberseitigen Bereich Aussparungen vorgesehen sind, in welche die überstehenden Konturen 4 der Funktionsschicht 3 hineinragen. Dieser oberseitige Teil der Trägerschicht 2 bildet demnach einen Teil der Negativmaskenschicht 9.

Oberhalb der Trägerschicht 2 bzw. der Funktionsschicht 3 ist zudem bei der in Fig. 4 dargestellten Ausführungsform eine zusätzliche, durchgehende Lackschicht 10 vorgesehen, um eine besonders ebene Fläche für die darauf angeordneten Schichten bereit zu stellen. Die Negativmaskenschicht 9 wird im hier gezeigten Beispiel also nicht allein durch ein Material gebildet, sondern setzt sich zusammen aus dem oberen Teil der Trägerschicht 2 mit entsprechenden Aussparungen für die überstehenden Konturen 4 und einer abschließenden unterbrechungsfreien Lackschicht 10. Auf diese Weise lassen sich, ähnlich wie im Fall der in Fig. 2 gezeigten Ausführungsform, weitere Schichten, wie eine Dekorschicht 6 und eine Deckschicht 7, über ihre gesamte Fläche absolut plan auf der Negativmaskenschicht 9 oberhalb der Funktionsschicht 3 anordnen.

Bei einem erfindungsgemäßen Belagselement 1 entsprechend dem hier gezeigten Ausführungsbeispiel sind die Aussparungen in die Trägerschicht eingefräst oder auch eingeschnitten. Dabei können verschiedene Aussparungen unterschiedlich tief in die Trägerschicht 2 eingebracht sein. Durch eine Anpassung der jeweiligen Aussparung an die zugeordnete überstehende Kontur 4, die von der Aussparung aufgenommen werden soll, lässt sich ein fluchtender Abschluss der überstehenden Konturen 4 der Funktionsschicht 3 mit der Oberseite der Trägerschicht 2 erreichen. Auch ohne eine zusätzliche, ununterbrochene Lackschicht 10 ist in diesem Fall eine ebene Basisfläche für die Aufbringung weiterer Schichten vorhanden, wie in Fig. 5 dargestellt ist.

In ähnlicher Weise wie die Trägerschicht 2 kann auch die Dekorschicht 6, wie in Fig. 6 dargestellt, und/oder die Deckschicht 7 Aussparungen zur Aufnahme von überstehenden Konturen 4 der Funktionsschicht 3 aufweisen. Auch in diesem Fall ist die als Dekorschicht 6 oder als oberseitige Deckschicht 7 ausgebildete Negativmaskenschicht 9 an der Unterseite derart geformt, dass Aussparungen zur Aufnahme überstehender Konturen 4 der Funktionsschicht 3 vorgesehen sind. Dementsprechend füllt das Material der Negativmaskenschicht 9, welches die Aussparungen umgibt, die Zwischenräume 5 zwischen den überstehenden Konturen 4 der Funktionsschicht 3 auf. Auf der der Funktionsschicht 3 abgewandten Seite der Negativmaskenschicht 9 ist diese letztlich auch im Fall einer gleichzeitigen Funktion als Dekorschicht 6 oder als Deckschicht 7 durchgehend eben. Nachfolgende Schichten können dementsprechend auf die Negativmaskenschicht 9 aufgebracht werden, ohne dass sich störende Konturen, insbesondere mit fühl- und/oder sichtbaren Kanten 8 an der Oberfläche des Belagselements 1 ausbilden.

Die Deckschicht 7 ist üblicherweise transparent oder zumindest transluzent ausgebildet, damit eine darunterliegende Dekorschicht 6 nicht verdeckt wird. Es versteht sich, dass auch im Fall, dass die Deckschicht 7 die Funktion einer Negativmaskenschicht 9 erfüllt, oder umgekehrt, diese zumindest bereichsweise auch transparent und/oder transluzent ausgebildet ist.

Weist die Funktionsschicht 3 aktive Komponenten auf, die eine optische Wirkung nach außen hin erzielen sollen, beispielsweise eine Leuchtschicht oder eine Anzeigeeinrichtung, so ist nicht nur die Deckschicht 7, sondern auch die Negativmaskenschicht 9 vorzugsweise transparent oder transluzent ausgebildet, so dass die funktionalen Elemente der Funktionsschicht 3 von außen her erkennbar sind. Im Fall einer Anzeigeeinrichtung wird im betreffenden Bereich vorzugsweise auf eine Dekorschicht 6 verzichtet. Im Fall einer Leuchtschicht kann diese dazu dienen, ein Dekor der Dekorschicht 6 zumindest bereichsweise zu hinterleuchten, so dass sich der Einsatz einer Leuchtschicht in der Funktionsschicht 3 zusammen mit einer Dekorschicht 6 nicht ausschließt. Dennoch ist die Negativmaskenschicht 9 in diesem Fall bevorzugt transparent oder transluzent ausgebildet, falls die Negativmaskenschicht 9 oberhalb der Funktionsschicht 3 angeordnet ist. Wenngleich die Leuchtschicht der Funktionsschicht 3 nicht als solche sichtbar ist, ist es dennoch notwendig, dass eine ausreichende Lichtmenge zu den oberen Schichten, insbesondere zur Dekorschicht 6 und durch diese hindurch gelangt.

Durch eine nur bereichsweise transparente bzw. transluzente Ausbildung der Negativmaskenschicht 9 oberhalb der Funktionsschicht 3 ist es zudem möglich, bestimmte Bereiche einer Leuchtschicht der Funktionsschicht 3 optisch zu maskieren, und somit ein bestimmtes Muster, insbesondere bei der Hinterleuchtung der Dekorschicht 6, zu erzielen.

### Bezugszeichenliste:

- 1: Belagselement
- 2: Trägerschicht
- 3: Funktionsschicht
- 4: überstehende Kontur
- 5: Zwischenraum
- 6: Dekorschicht
- 7: Deckschicht
- 8: Kante
- 9: Negativmaskenschicht
- 10: Lackschicht

## Patentansprüche

1. Belagselement (1) für einen Boden-, Wand- oder Deckenbelag oder zur Verwendung als Möbelbauteil, insbesondere ein Plattenkörper oder eine Folie, mit einer Trägerschicht (2) und mit wenigstens einer Funktionsschicht (3),
wobei wenigstens eine Negativmaskenschicht (9) zum Ausgleich von überstehenden Konturen (4), insbesondere einer gedruckten Schaltung, der Funktionsschicht (3) vorgesehen ist, wobei die Negativmaskenschicht (9) wenigstens eine Aussparung zur Aufnahme von überstehenden Konturen (4) der Funktionsschicht (3) aufweist und
wobei die Negativmaskenschicht (9) zumindest teilweise von einem Teil der Trägerschicht (2) gebildet wird, **dadurch gekennzeichnet, dass** die Trägerschicht (2) wenigstens eine eingefräste und/oder eingeschnittene Aussparung zur Aufnahme von überstehenden Konturen (4) der Funktionsschicht (3) aufweist.

2. Belagselement nach Anspruch 1, **dadurch gekennzeichnet, dass** die Negativmaskenschicht (9) unmittelbar oberhalb und/oder unterhalb der Funktionsschicht (3) angeordnet ist und/oder dass die der Funktionsschicht (3) abgewandte Seite der Negativmaskenschicht (9) zumindest im wesentlichen über ihre gesamte Fläche eben ist.

3. Belagselement nach Anspruch 1 oder 2, **dadurch gekennzeichnet, dass** die Negativmaskenschicht (9) sich lateral zumindest im wesentlichen über das gesamte Belagselement (1) erstreckt und/oder an ihrer der Funktionsschicht (3) abgewandten Seite eine unterbrechungsfreie Schicht aufweist.

4. Belagselement nach einem der vorhergehenden Ansprüche, **dadurch gekennzeichnet, dass** die Negativmaskenschicht (9) im Bereich der Funktionsschicht (3) eine geringere Schichtdicke aufweist als in Bereichen, in denen keine Funktionsschicht (3) vorgesehen ist.

5. Belagselement nach einem der vorhergehenden Ansprüche, **dadurch gekennzeichnet, dass** eine Mehrzahl von Funktionsschichten (3) vorgesehen ist, wobei jeder Funktionsschicht (3) wenigstens eine Negativmaskenschicht (9) zugeordnet ist, und/oder dass eine Mehrzahl von Negativmaskenschichten (9) vorgesehen ist.

## Claims

1. Covering element (1) for a floor, wall or ceiling covering or for use as a furniture component, in particular a panel body or a foil, having a carrier layer (2) and having at least one functional layer (3), wherein at least one negative mask layer (9) is provided for compensating for projecting contours (4), in particular a printed circuit, of the functional layer (3), wherein the negative mask layer (9) has at least one recess for receiving projecting contours (4) of the functional layer (3), and wherein the negative mask layer (9) is formed at least partially by a part of the carrier layer (2),
**characterized in that**
the carrier layer (2) has at least one milled and/or cut recess for receiving projecting contours (4) of the functional layer (3).

2. Covering element according to claim 1, **characterized in that** the negative mask layer (9) is arranged directly above and/or below the functional layer (3) and/or **in that** the side of the negative mask layer (9) facing away from the functional layer (3) is flat at least substantially over its entire surface.

3. Covering element according to claim 1 or 2, **characterized in that** the negative mask layer (9) extends laterally at least substantially over the entire covering element (1) and/or has an interruption-free layer on its side facing away from the functional layer (3).

4. Covering element according to one of the preceding claims, **characterized in that** the negative masking layer (9) has a smaller layer thickness in the region of the functional layer (3) than in regions in which no functional layer (3) is provided.

5. Covering element according to one of the preceding claims, **characterized in that** a plurality of functional layers (3) is provided, each functional layer (3) being assigned at least one negative mask layer (9), and/or **in that** a plurality of negative mask layers (9) is provided.

## Revendications

1. Elément de revêtement (1) pour un revêtement de sol, de mur ou de plafond ou pour l'utilisation en tant qu'élément de meuble, en particulier un corps de plaque ou une feuille, avec une couche de support (2) et avec au moins une couche fonctionnelle (3), au moins une couche de masque négatif (9) étant prévue pour la compensation de contours saillants (4), en particulier d'un circuit imprimé, de la couche fonctionnelle (3), la couche de masque négatif (9) comportant au moins un évidement pour recevoir des contours saillants (4) de la couche fonctionnelle (3), et la couche de masque négatif (9) étant formée au moins partiellement par une partie de la couche de support (2),
**caractérisé en ce**
**que** la couche de support (2) comporte au moins un évidement fraisé et/ou incisé pour recevoir des contours saillants (4) de la couche fonctionnelle (3).

2. Elément de revêtement selon la revendication 1, **caractérisé en ce que** la couche de masque négatif (9) est disposée directement au-dessus et/ou au-dessous de la couche fonctionnelle (3) et/ou **en ce que** le côté de la couche de masque négatif (9) opposé à la couche fonctionnelle (3) est plat au moins sensiblement sur toute sa surface.

3. Elément de revêtement selon la revendication 1 ou 2, **caractérisé en ce que** la couche de masque négatif (9) s'étend latéralement au moins sensiblement sur l'ensemble de l'élément de revêtement (1) et/ou comporte une couche ininterrompue sur son côté opposé à la couche fonctionnelle (3).

4. Elément de revêtement selon l'une des revendications précédentes, **caractérisé en ce que** la couche de masquage négatif (9) comporte une épaisseur de couche plus faible dans la zone de la couche fonctionnelle (3) que dans les zones dans lesquelles aucune couche fonctionnelle (3) n'est prévue.

5. Elément de revêtement selon l'une des revendications précédentes, **caractérisé en ce qu'**il est prévu une pluralité de couches fonctionnelles (3), à chaque couche fonctionnelle (3) étant associée au moins une couche de masque négatif (9), et/ou **en ce qu'**il est prévu une pluralité de couches de masque négatif (9).
